# EUROPÄISCHE PATENTSCHRIFT

(11) **EP 3 001 508 B1**
(45) Veröffentlichungstag und Bekanntmachung des Hinweises auf die Patenterteilung: **17.06.2020**
(21) Anmeldenummer: 15185446.0
(22) Anmeldetag: 16.09.2015
(51) Int. Cl.: H01R 12/57, H01L 23/498, H01R 12/91, H01R 43/02, H01R 12/70

(54) **KONTAKTANORDNUNG MIT EINEM SCHALTUNGSTRÄGER UND EINEM VERBINDUNGSELEMENT**
CONTACT ASSEMBLY WITH A CIRCUIT CARRIER AND A CONNECTION ELEMENT
SYSTEME DE CONTACT DOTE D'UN PORTE-CIRCUIT ET ELEMENT DE LIAISON

(30) Priorität: 26.09.2014 DE 102014219585
(43) Veröffentlichungstag der Anmeldung: 30.03.2016
(73) Patentinhaber: Robert Bosch GmbH, 70442 Stuttgart (DE)
(72) Erfinder: Sentuerk, Tuncay, 72762 Reutlingen (DE); Sueske, Erik, 72764 Reutlingen (DE); Baer, Alexander, 72760 Reutlingen (DE); Kienzle, Uta, 72072 Tuebingen (DE); Orso, Steffen, 72764 Reutlingen (DE); Barsukova, Tatiana, 57072 Siegen (DE); Keil, Manuela, 72622 Nuertingen (DE)

(56) Entgegenhaltungen:
- EP-A1- 2 028 692
- WO-A1-2013/171136
- DE-U1- 20 313 285
- JP-A- 2010 278 107
- JP-B2- 5 585 547
- US-A1- 2007 228 413
- US-A1- 2008 087 994
- US-A1- 2010 295 187

## Beschreibung

### Stand der Technik

Die Erfindung betrifft eine Kontaktanordnung. Die Kontaktanordnung weist einen Schaltungsträger auf, insbesondere einen DBC-Schaltungsträger, AMB-Schaltungsträger oder einen HTTC- oder LTCC-Schaltungsträger. Der Schaltungsträger weist wenigstens eine elektrisch isolierende Schicht und wenigstens eine mit der elektrisch isolierenden Schicht - insbesondere aufeinanderliegend - verbundene elektrisch leitfähige Schicht auf. Die Kontaktanordnung weist auch eine Stromschiene auf, welche mit der elektrisch leitfähigen Schicht des Schaltungsträgers elektrisch verbunden ist. EP 2 028 692 A1 offenbart eine Kontaktanordnung gemäß dem Oberbegriff von Anspruch 1.

### Offenbarung der Erfindung

Erfindungsgemäß weist der Schaltungsträger ein elektrisch leitfähiges, federnd ausgebildetes Verbindungselement auf. Das Verbindungselement weist wenigstens einen Befestigungsfuß, bevorzugt wenigstens zwei Befestigungsfüße auf, wobei der Befestigungsfuß mit der elektrisch leitfähigen Schicht stoffschlüssig verbunden, insbesondere mittels eines Lotmittels lötverbunden, mittels eines Sintermaterials sinterverbunden, oder mittels eines elektrisch leitfähigen Klebstoffs klebeverbunden ist. Das Verbindungselement weist auch einen von dem Schaltungsträger beabstandet angeordneten Verbindungsabschnitt zum Verbinden mit der Stromschiene auf. Der Verbindungsabschnitt ist über ein Abstandsbein mit dem Befestigungsfuß verbunden. Die Stromschiene ist bevorzugt mit dem Verbindungsabschnitt elektrisch und mechanisch verbunden. So kann der Schaltungsträger vorteilhaft über das Verbindungselement mit der Stromschiene elektrisch verbunden sein, wobei über die Stromschiene einwirkende Vibrationen oder Bewegungen der Stromschiene, insbesondere Relativbewegungen zwischen der Stromschiene und dem Schaltungsträger, welche beispielsweise durch Temperaturwechsel verursacht werden, über das federnd ausgebildete Verbindungselement vorteilhaft abgefangen werden können. Weiter vorteilhaft kann so die Stromschiene mittels eines aufwandsgünstigen und haltbaren elektrischen und mechanischen Verbindungsverfahren mit dem Abstandselement, und so mit dem Schaltungsträger, elektrisch verbunden werden. Beispielsweise kann zum Verbinden der Stromschiene mit dem Schaltungsträger das Verbindungselement gemeinsam mit anderen elektronischen Bauelementen in einem Reflow-Lötofen mit dem Schaltungsträger verlötet werden. Anschließend kann in einem weiteren Verbindungsschritt die Stromschiene mit dem Verbindungselement verlötet, verschweißt, vernietet oder verschraubt werden. So kann vorteilhaft auch eine beim Verbinden der Stromschiene mit dem Verbindungselement entstehende Kraft, Temperatur oder Vibration nicht unmittelbar auf den Schaltungsträger wirken und dort beispielsweise zu einer Delamination von elektrisch leitfähigen und elektrisch isolierenden Schichten oder einer Schädigung weiterer elektronischer Bauelemente führen.

Der Schaltungsträger ist bevorzugt ein keramischer Schaltungsträger, insbesondere ein DBC-Schaltungsträger (DBC = Direct-Bonded-Copper), AMB-Schaltungsträger (AMB = Active-Metal-Brazed) oder ein HTTC-Schaltungsträger (HTCC = High-Temperature-Cofired-Ceramics) oder LTCC-Schaltungsträger (LTCC = Low-Temperature-Cofired-Ceramics). Der keramsiche Schaltungsträger kann durch das Verbindungselement vorteilhaft bei einer Krafteinwirkung über die Stromschiene nicht zerbrechen.

Die Stromschiene ist bevorzugt durch einen Blechabschnitt, einen Blechstreifen, ein gestanztes oder lasergeschnittenes Blechstück, auch Lead-Frame oder Stanzgitter genannt, gebildet. Bevorzugt ist im Querschnitt der Stromschiene eine Breitenerstreckung größer als eine Dickenerstreckung. Eine Dickenerstreckung beträgt beispielsweise zwischen 0,5 und 5 Millimeter.

Bevorzugt ist der Verbindungsabschnitt durch einen Blechabschnitt gebildet, welcher einen Oberflächenbereich zum Kontaktiertwerden durch die Stromschiene aufweist. Der Verbindungsabschnitt ist bevorzugt federnd ausgebildet, und kann - beispielsweise nach Art einer Blattfeder - quer zu seiner flachen Erstreckung einfedern.

In einer bevorzugten Ausführungsform ist der Verbindungsabschnitt über einen radial abweisenden Federarm mit dem Abstandsbein verbunden. Der Federarm ist bevorzugt durch eine Blattfeder gebildet. So kann der Verbindungsabschnitt vorteilhaft quer zu einer flachen Erstreckung des Schaltungsträgers einfedern.

Erfindungsgemäß weist das Verbindungselement drei jeweils federnd ausgebildete Abstandsbeine auf, welche jeweils einen Befestigungsfuß aufweisen und welche jeweils an einen Federarm angeformt sind. So kann vorteilhaft eine stabile Anordnung zum Befestigen der Stromschiene mit dem Schaltungsträger gebildet sein, wobei weiter vorteilhaft Kräfte oder Bewegungen, welche von der Stromschiene parallel zu einer flachen Erstreckung des Schaltungsträgers auf dem Verbindungsabschnitt einwirken, durch die Abstandsbeine federnd abgefangen werden können.

Bevorzugt erstrecken sich die Abstandsbeine jeweils in einem vorbestimmten Winkel zur flachen Erstreckung des Schaltungsträgers. Der vorbestimmte Winkel ist beispielsweise ein rechter Winkel, sodass die Abstandsbeine sich mit ihrer Längserstreckung quer zu einer flachen Erstreckung des Verbindungsabschnitts, und so auch quer zum Schaltungsträger, erstrecken. Dadurch kann vorteilhaft eine Federeigenschaft des Abstandsbeins gebildet sein.

Vorteilhaft ist durch die Abstandsbeine zwischen dem Verbindungsabschnitt und dem Schaltungsträger ein Hohlraum gebildet, sodass zum Verbinden des Verbindungsabschnitts mit der Stromschiene ein Werkzeug, beispielsweise eine Zange zum Widerstandsschweißen oder eine Zange zum Vernieten der Stromschiene mit dem Verbindungsabschnitt, in den Hohlraum eingreifen kann.

Die Federarme erstrecken sich jeweils erfindungsgemäß in der flachen Erstreckung des Verbindungsabschnitts radial abweisend. Weiter erfindungsgemäß schließen zueinander unmittelbar benachbarte Federarme einen Winkel von 120 Grad zwischeneinander ein. So ist vorteilhaft eine sternförmige Anordnung der Federarme und der Abstandsbeine gebildet, sodass Bewegungen der Stromschiene, welche parallel zum Schaltungsträger auf das Verbindungselement einwirken, aus nahezu allen Richtungen unter dem Verbindungsabschnitt umlaufend von dem Verbindungselement, insbesondere dem Abstandsbeinen, federnd abgefangen werden können.

In einer bevorzugten Ausführungsform der Kontaktanordnung ist das Verbindungselement mit der Stromschiene mittels wenigstens eines Nietelements vernietet. Das Nietelement ist bevorzugt ein Metall-Nietelement, weiter bevorzugt ein Kupfer-Nietelement. Bevorzugt weist die Stromschiene und der Verbindungsabschnitt jeweils einen Durchbruch zum Durchführen des Nietelements auf. So kann das Verbindungselement vorteilhaft einfach und aufwandsgünstig mittels einer Nietzange und eines Nietelements mit der Stromschiene elektrisch leitfähig, insbesondere galvanisch durch Berühren elektrisch leitend, und mechanisch fest verbunden werden.

In einer bevorzugten Ausführungsform ist das Verbindungselement mit der Stromschiene verschweißt, insbesondere mittels Widerstandsschweißen verschweißt. So kann die Stromschiene vorteilhaft zum elektrischen und mechanischen Verbinden auf das Verbindungselement, insbesondere den Verbindungsabschnitt, aufgelegt werden, wobei in einem weiteren Verbindungsschritt eine Widerstandsschweißzange in den zwischen dem Verbindungsabschnitt und dem Schaltungsträger verbleibenden Hohlraum eingreifen kann und so die Stromschiene und den Verbindungsabschnitt zwischen zwei Zangenbacken festhalten und miteinander verschweißen kann.

In einer bevorzugten Ausführungsform ist das Verbindungselement mit der Stromschiene verlötet, insbesondere mittels Hartlöten verlötet, oder mittels Weichlöten, insbesondere Selektivweichlöten verlötet. So kann die Stromschiene vorteilhaft in einem weiteren Verbindungsschritt nach einem Reflow-Verlöten des Schaltungsträgers mit dem Verbindungselement oder zusätzlich mit weiteren elektronischen Bauelementen mit dem Verbindungselement selektivverlötet werden.

In einer bevorzugten Ausführungsform erstrecken die Abstandsbeine sich quer zu einer flachen Erstreckung des Verbindungsabschnitts. So kann vorteilhaft platzsparend ein Hohlraum zwischen dem Verbindungsabschnitt und dem Schaltungsträger gebildet sein. Die Abstandsbeine erstrecken sich bevorzugt jeweils parallel zueinander beabstandet.

In einer bevorzugten Ausführungsform sind die Stromschiene und das Verbindungselement jeweils aus Blech, insbesondere aus Kupferblech, gebildet. Bevorzugt ist die Legierung eine Legierung Legierung umfassend Kupfer und Zinn, insbesondre eine CuSn6-Kupferlegierung oder eine CuSn0.15-Kupferlegierung, beispielsweise gemäß der Norm UNS C14415. Bevorzugt ist das Kupferblech aus einer Kupferlegierung gemäß der Norm UNS C18080 gebildet. Die Kupferlegierung weist bevorzugt eine Beimengung umfassend Chrom, Silber, Eisen, Titan, Silizium und zum größten Teil Kupfer auf. Die Anteile der Beimengung betragen jeweils bevorzugt 0,5 % Chrom, 0,1 % Silber, 0,08 % Eisen, 0,06 % Titan und 0,03 % Silizium. Eine elektrische Leitfähigkeit des Verbindungselements beträgt bevorzugt wenigstens 30, bevorzugt 46 Mega-Siemens pro Meter.

So kann sowohl die Stromschiene, als auch das Verbindungselement vorteilhaft durch Stanzen oder durch Laserschneiden aus einem Blech erzeugt werden. Das Verbindungselement, insbesondere die zuvor erwähnten Teile des Verbindungselements, umfassend den Verbindungsabschnitt, die Federarme, die Abstandsbeine und die Befestigungsfüße, können vorteilhaft nach einem Ausstanzen eines Roh-Verbindungselements aus einem flachen Blech durch Abwinkeln an Knicklinien erzeugt werden. Der Verbindungsabschnitt kann beispielsweise durch eine zentral angeordnete Platte aus Blech gebildet sein, wobei an die Platte radial abweisende Blechstreifen zum Ausbilden der Abstandsbeine und der Befestigungsfüße oder zusätzlich der Federarme angeformt sind.

Das Abstandsbein kann so beispielsweise durch Abwinkeln des Blechstreifens erzeugt werden, wobei ein sich zwischen der Platte als Verbindungsabschnitt und dem Abstandsbein erstreckender Blechstreifen den Federarm ausbilden kann. Das Abstandsbein kann mit einem Endabschnitt abgewinkelt werden, sodass so auf einfache Weise der Befestigungsfuß gebildet ist, welcher an das Abstandsbein angeformt ist.

Ein nicht beanspruchtes Beispiel betrifft auch ein Verfahren zum Verbinden eines Schaltungsträgers mit einer Stromschiene. Der Schaltungsträger weist eine elektrisch leitfähige Schicht und eine elektrisch isolierende Schicht auf. Bei dem Verfahren wird ein elektrisch leitfähiges und federnd ausgebildetes Verbindungselement, umfassend einen Verbindungsabschnitt zum Verbinden mit der Stromschiene und wenigstens zwei mit dem Verbindungsabschnitt verbundene Befestigungsfüße, mit den Befestigungsfüßen mit der elektrisch leitfähigen Schicht verlötet, sodass ein Verbindungsabschnitt von dem Schaltungsträger beabstandet ist. Bei dem Verfahren wird der Verbindungsabschnitt und ein Endabschnitt der Stromschiene elektrisch leitfähig und mechanisch fest miteinander vernietet oder verschweißt.

Bevorzugt greift zum Verschweißen eine zum Schweißverbinden ausgebildete Zange in eine zwischen dem Verbindungsabschnitt und dem Schaltungsträger gebildeten Hohlraum ein. Weiter bevorzugt wird der Endabschnitt der Stromschiene und der Verbindungsabschnitt von der zum Schweißverbinden ausgebildeten Zange umgriffen und mittels Widerstandsschweißen miteinander verschweißt.

Bevorzugt greift eine zum Vernieten ausgebildete Zange in einen zwischen dem Verbindungsabschnitt und dem Schaltungsträger gebildeten Hohlraum ein. Weiter bevorzugt umgreift die zum Vernieten ausgebildete Zange den Endabschnitt der Stromschiene und den Verbindungsabschnitt und führt ein Nietelement durch einen in dem Endabschnitt und in dem Verbindungsabschnitt jeweils ausgebildeten Durchbruch und verpresst das Nietelement derart, dass das Nietelement den Verbindungsabschnitt und den Endabschnitt der Stromschiene jeweils formschlüssig hintergreift.

Bevorzugt ist die Kontaktanordnung ausgebildet, einen Strom zwischen 100 und 600 Ampere über die Stromschiene und das Verbindungselement zu führen.

Die Erfindung wird nun im Folgenden anhand von Figuren und weiteren Ausführungsbeispielen beschrieben. Weitere vorteilhafte Ausführungsvarianten ergeben sich aus den in den Figuren und in den abhängigen Ansprüchen beschriebenen Merkmalen.
Figur 1 zeigt ein nicht beanspruchtes Beispiel für eine Kontaktanordnung umfassend einen Schaltungsträger, der über ein Verbindungselement mit einer Stromschiene verbunden ist;
Figur 2 zeigt ein Ausführungsbeispiel für ein Verbindungselement, das drei federnd ausgebildete Abstandsbeine aufweist;
Figur 3 zeigt eine Aufsicht auf ein Blechstück, das zum Ausbilden des in Figur 2 gezeigten Verbindungselements an Knicklinien abgewinkelt werden kann.

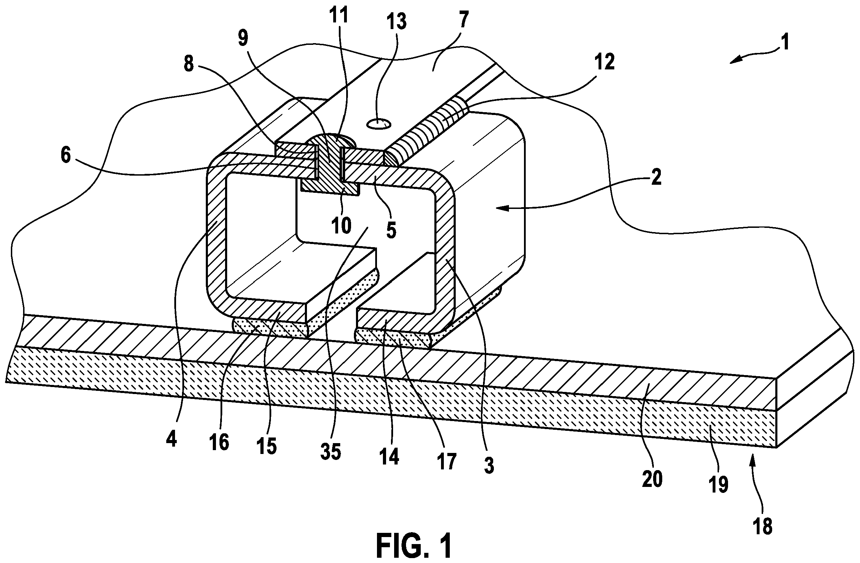

Figur 1 zeigt - schematisch - ein nicht beanspruchtes Beispiel für eine Kontaktanordnung 1. Die Kontaktanordnung 1 weist ein Verbindungselement 2 auf. Das Verbindungselement 2 ist in diesem Beispiel U-förmig ausgebildet. Das Verbindungselement 2 weist ein Abstandsbein 3 auf und ein zu dem Abstandsbein 3 parallel beabstandetes Abstandsbein 4. Die Abstandsbeine 3 und 4 sind jeweils durch einen abgewinkelten Abschnitt eines Blechstreifens gebildet. Die Abstandsbeine 3 und 4 sind jeweils über einen Verbindungsabschnitt 5 miteinander verbunden. Die Abstandsbeine 3 und 4 erstrecken sich jeweils orthogonal zu dem Verbindungsabschnitt 5.

An das Abstandsbein 3 ist ein Befestigungsfuß 14 angeformt, welcher sich quer zu dem Abstandsbein 3, von dem Verbindungsabschnitt 5 abweisend erstreckt. An das Abstandsbein 4 ist ein Befestigungsfuß 15 angeformt, welcher sich quer zu dem Abstandsbein 4 und sich parallel zu dem Verbindungsabschnitt 5 erstreckt.

Das Verbindungselement 2 ist in diesem Beispiel aus einem Blechstreifen, insbesondere Kupferblechstreifen, durch Abwinkeln der zuvor genannten Teilabschnitte wie den Befestigungsfuß 15, das Abstandsbein 4, den Verbindungsabschnitt 5, das Abstandsbein 3 und den Befestigungsfuß 14 gebildet. Die Befestigungsfüße 14 und 15 weisen in diesem Ausführungsbeispiel aufeinander zu und erstrecken sich parallel zu dem Verbindungsabschnitt 5.

In einer anderen - in Figur 1 nicht dargestellten - beispielhaften Form weisen die Befestigungsfüße 14 und 15 jeweils voneinander ab.

Die Abstandsbeine 3 und 4 sind jeweils als Blechstreifenabschnitt ausgebildet, und so - als Blattfeder- federnd ausgebildet, wobei eine zusätzliche Feder durch die Abwinkelung zu dem jeweiligen Befestigungsfuß und zu dem Verbindungsabschnitt 5 hin gebildet ist.

Der Verbindungsabschnitt 5 weist in diesem Beispiel einen Durchbruch 6 zum Verbinden mit einer Stromschiene 7 auf. Die Stromschiene 7 ist in diesem Beispiel durch einen Blechstreifen, insbesondere Kupferblechstreifen, gebildet. Die Stromschiene 7 weist einen Durchbruch 8 zum Verbinden, in diesem Beispiel zum Nietverbinden, mit dem Verbindungsabschnitt 5 auf. Die Kontaktanordnung 1 umfasst in diesem Ausführungsbeispiel auch ein Nietelement 9. Das Nietelement 9 ist in diesem Beispiel mit einem Längsabschnitt in dem Durchbruch 6 angeordnet und in einem dazu benachbart angeordneten Längsabschnitt des Nietelements 9 in dem Durchbruch 8 angeordnet. Das Nietelement 9 weist einen Nietkopf 10 auf, welcher durch einen radial abweisenden Kragen gebildet ist und welcher ausgebildet ist, einen Rand im Bereich des Durchbruchs 8 des Verbindungsabschnitts 5 formschlüssig zu hintergreifen. Das Nietelement 9 weist in diesem Beispiel auch einen Nietkopf 11 auf, welcher sich radial abweisend erstreckt und ausgebildet ist, die Stromschiene 7 im Bereich des Durchbruchs 8 formschlüssig zu hintergreifen. Das Nietelement 9 ist ausgebildet, die Stromschiene 7 und den Verbindungsabschnitt 5 einander zusammenzupressen und verbunden zu halten.

Der Nietkopf 10 und/oder der Nietkopf 11 sind jeweils durch Kaltumformen, beispielsweise mittels einer - in Figur 1 nicht dargestellten - Nietzange, erzeugt, welche zum Verbinden der Stromschiene 7 mit dem Verbindungsabschnitt 5 in den Hohlraum 35 eingreifen kann.

Der Befestigungsfuß 15 ist in diesem Beispiel mittels eines Lotmittels 16 mit einer elektrisch leitfähigen Schicht 20 eines Schaltungsträgers 18 verbunden. Der Befestigungsfuß 14 ist mittels eines Lotmittels 17 mit der elektrisch leitfähigen Schicht 20 verbunden. Die Befestigungsfüße 14 und 15 sind beispielsweise mittels Reflow-Löten in einem Lötofen mit der elektrisch leitfähigen Schicht 20 verlötet. Die elektrisch leitfähige Schicht 20 ist in diesem Ausführungsbeispiel mit ihrer flachen Erstreckung mit einer weiteren Schicht, nämlich einer elektrisch isolierenden Schicht 19, verbunden. Die elektrisch isolierende Schicht 19 ist in diesem Beispiel durch eine Keramikschicht gebildet. Der Schaltungsträger 8 ist in diesem Beispiel durch ein DBC-Substrat (DBC = Direct-Bonded-Copper) gebildet.

Das Verbindungselement 2 umschließt mit der zuvor genannten U-Form, bei der die Abstandsbeine 3 und 4 jeweils einen U-Schenkel bilden, einen Hohlraum 35. In den Hohlraum 35 kann zum Verbinden der Stromschiene 7 mit dem Verbindungsabschnitt 5 eine Zangenbacke einer Nietzange eingreifen. Die Nietzange kann so zum Kaltumformen des Nietelements 9 zum Ausbilden des Nietkopfes 11, oder zusätzlich des Nietkopfes 10, den Verbindungsabschnitt 5 und die Stromschiene 7 gemeinsam aufeinanderliegend umgreifen.

Anstelle des Nietelements 9 oder zusätzlich zu dem Nietelement 9 kann die Stromschiene 7 mit dem Verbindungsabschnitt 5 mittels einer Schweißverbindung 12, gebildet durch eine Schweißraupe, verbunden sein.

Die Stromschiene 7 kann mit dem Verbindungsabschnitt 5 zusätzlich oder unabhängig von dem Nietelement 9 und der Schweißverbindung 12 mittels einer Widerstands-Schweißverbindung 13, in diesem Beispiel gebildet durch einen Schweißpunkt, stoffschlüssig verbunden sein. Zum Erzeugen der Widerstandsschweißverbindung 13 kann eine Schweißzange mit einer Zangenbacke in den Hohlraum 35 eingreifen und mit einer weiteren Zangenbacke auf die Stromschiene 7 pressen und die Stromschiene 7 und den Verbindungsabschnitt 5 einander zusammenpressen und mittels eines Schweißstromes unter Erzeugung der Schweißverbindung 13 stoffschlüssig miteinander verbinden.

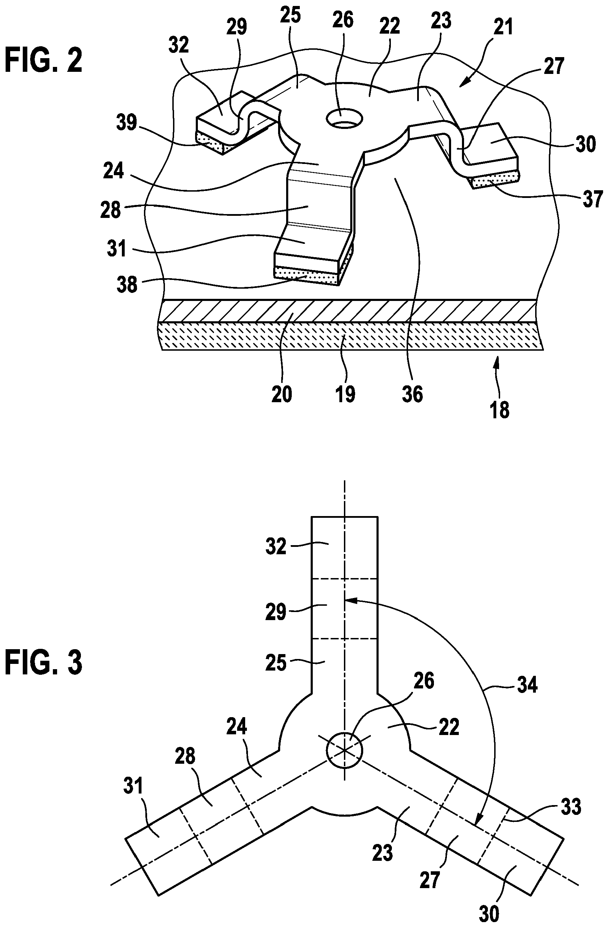

Figur 2 zeigt - schematisch - ein Ausführungsbeispiel für ein Verbindungselement 21, welches anstelle des in Figur 1 gezeigten Verbindungselements 2 mit der Stromschiene 7 und dem Schaltungsträger 18 als Bestandteil der Kontaktanordnung 1 verbunden sein kann. Das Verbindungselement 21 weist einen Verbindungsabschnitt 22 auf, welcher in diesem Ausführungsbeispiel durch ein wenigstens umfangsabschnittsweise rund ausgebildetes Blechelement gebildet ist. Der Verbindungsabschnitt 22 in diesem Ausführungsbeispiel mit einem Federarm 23, einem Federarm 24 und einem Federarm 25 verbunden, welche jeweils an den Verbindungsabschnitt 22 angeformt sind und sich radial abweisend von dem Verbindungsabschnitt 22 erstrecken.

Das Verbindungselement 21 weist auch ein Abstandsbein 27 auf, welches an den Federarm 23 angeformt ist und sich quer zu dem Federarm 23 erstreckt. Das Verbindungselement 21 weist auch ein Abstandsbein 28 auf, welches sich quer erstreckend an den Federarm 24 angeformt ist. An den Federarm 25 ist ein sich zu dem Federarm 25 quer erstreckendes Abstandsbein 29 angeformt.

An das Abstandsbein 27 ist ein Befestigungsfuß 30 angeformt, welcher sich von dem Verbindungsabschnitt 22 insbesondere radial abweisend erstreckt. An das Abstandsbein 28 ist ein Befestigungsfuß 31 angeformt, welcher sich zu dem Abstandsbein 28 abgewinkelt und vom Verbindungsabschnitt 22 insbesondere radial abweisend erstreckt. An das Abstandsbein 29 ist ein Befestigungsfuß 32 angeformt, welcher sich von dem Verbindungsabschnitt 22 insbesondere radial abweisend erstreckt. Der Befestigungsfuß 30 ist mittels eines Lotmittels 37, der Befestigungsfuß 31 mittels eines Lotmittels 38 und der Befestigungsfuß 32 mittels eines Lotmittels 39 mit dem Schaltungsträger lötverbunden.

Die Befestigungsfüße 30, 31, und 32 können anders als in Figur 2 dargestellt, auch radial nach innen zu dem Verbindungsabschnitt 22 weisend angeordnet sein.

In dem Verbindungsabschnitt 22 ist ein Durchbruch 26 gebildet, sodass der Verbindungsabschnitt 22 mittels eines Nietelements oder eines Schraubelements mit einer Stromschiene elektrisch leitfähig und mechanisch verbunden werden kann.

Dazu kann eine - in Figur 2 nicht dargestellte - Niet- oder Schweißzange in einen zwischen dem Verbindungsabschnitt 22 und dem in Figur 1 dargestellten Schaltungsträger 18 ausgebildeten Hohlraum 36 eingreifen.

Figur 3 zeigt ein in diesem Ausführungsbeispiel gestanztes oder lasergeschnittenes Blechstück, aus dem durch Falten von Teilen des Blechs das in Figur 2 dargestellte Verbindungselement 21 erzeugt werden kann. Von dem zentral angeordneten Verbindungsabschnitt 22 mit dem zentral in dem Verbindungsabschnitt 22 angeordneten Durchbruch 26 erstreckt sich radial nach außen ein Blechstreifen zum Ausbilden des Federarms 23, des Abstandsbeins 27 und des Befestigungsfußes 30. Der Befestigungsfuß 30 kann durch Abwinkeln entlang einer Knicklinie 33 gebildet werden. Zum Ausbilden des Abstandsbeins 27 kann der Längsabschnitt des Blechstreifens für das Abstandsbein 27 von dem Federarm 23 abgewinkelt werden. Eine Knicklinie ist gestrichelt gekennzeichnet.

Mit dem Verbindungsabschnitt 22 ist auch ein weiterer Blechstreifen radial abweisend verbunden. Ein Längsabschnitt des Blechstreifens ist zum Ausbilden eines Federarms 25 ausgebildet und ein radial nach außen zu dem Längsabschnitt für den Federarm angeordneter Längsabschnitt ist zum Ausbilden des in Figur 2 dargestellten Abstandsbeins 29 ausgebildet. Ein Endabschnitt des Blechstreifens ist zum Ausbilden des Befestigungsfußes 32 ausgebildet.

Das Abstandsbein 29 kann so durch Abwinkeln des Längsabschnitts für das Abstandsbein 29 entlang einer gestrichelt dargestellten Knicklinie erzeugt werden. Der Befestigungsfuß 32 kann von dem Abstandsbein 29 abgewinkelt werden.

Dargestellt ist auch ein radial abweisender Blechstreifen umfassend einen Längsabschnitt zum Erzeugen des Federarms 24, weiter radial nach außen eines Längsabschnitts zum Erzeugen des Abstandsbeins 28 und daran anschließend ein Endabschnitt zum Erzeugen des Befestigungsfußes 31. Der Befestigungsfuß 31 und das Abstandsbein 28 können jeweils durch Abwinkeln des Blechstreifens an den gestrichelt dargestellten Knicklinien erzeugt werden.

Der Blechstreifen umfassend den Längsabschnitt für das Abstandsbein 27 und der Blechstreifen umfassend den Längsabschnitt für das Abstandsbein 29 sind jeweils in Umlaufrichtung um den Durchbruch 26 zueinander benachbart angeordnet und schließen einen Winkel 34 zwischeneinander ein. Der Winkel 34 beträgt in diesem Ausführungsbeispiel 120 Grad. Die Federarme 23, 24 und 25 und die daran angeformten Abstandsbeine 27, 28 beziehungsweise 29 erstrecken sich so ausgehend von dem Verbindungsabschnitt 22 sternförmig radial nach außen.

## Patentansprüche

1. Kontaktanordnung (1) mit einem Schaltungsträger (18), und einer Stromschiene (7), wobei der Schaltungsträger (18) wenigstens eine elektrisch isolierende Schicht (19) und wenigstens eine mit der elektrisch isolierenden Schicht (19) verbundene elektrisch leitfähige Schicht (20) aufweist, wobei der Schaltungsträger (18) ein elektrisch leitfähiges, federnd ausgebildetes Verbindungselement (21) aufweist, wobei das Verbindungselement (21) wenigstens einen Befestigungsfuß (30, 31, 32) aufweist, welcher mit der elektrisch leitfähigen Schicht (20) lötverbunden ist, wobei das Verbindungselement (21) einen von dem Schaltungsträger (18) beabstandet angeordneten Verbindungsabschnitt (22) aufweist, wobei die Stromschiene (7) mit dem Verbindungsabschnitt (22) elektrisch und mechanisch verbunden ist, wobei das Verbindungselement (21) drei Abstandsbeine (27, 28, 29) aufweist und der Verbindungsabschnitt (22) jeweils über einen Federarm (23, 24, 25) mit dem jeweiligen Abstandsbein (27, 28, 29) verbunden ist, wobei die Abstandsbeine (27, 28, 29) jeweils einen Befestigungsfuß (30, 31, 32) aufweisen, welcher an den jeweiligen Federarm (23, 24, 25) angeformt ist,
**dadurch gekennzeichnet, dass**
sich die Federarme jeweils in der flachen Erstreckung des Verbindungsabschnitts radial abweisend erstrecken und zueinander unmittelbar benachbarte Federarme einen Winkel von 120 Grad zwischeneinander einschließen, sodass eine sternförmige Anordnung der Federarme und der Abstandsbeine gebildet ist.

2. Kontaktanordnung (1) nach Anspruch 1,
**dadurch gekennzeichnet, dass**
das Verbindungselement (21) mit der Stromschiene (7) mittels wenigstens eines Nietelements (9) vernietet ist.

3. Kontaktanordnung (1) nach Anspruch 1,
**dadurch gekennzeichnet, dass**
das Verbindungselement (21) mit der Stromschiene (7) verschweißt, insbesondere mittels Widerstandsschweißen verschweißt ist.

4. Kontaktanordnung (1) nach Anspruch 1,
**dadurch gekennzeichnet, dass**
das Verbindungselement (21) mit der Stromschiene (7) verlötet, insbesondere selektiv verlötet ist.

5. Kontaktanordnung (1) nach einem der vorhergehenden Ansprüche,
**dadurch gekennzeichnet, dass**
die Abstandsbeine (27, 28, 29) sich quer zu einer flachen Erstreckung des Verbindungsabschnitts (22) erstecken.

6. Kontaktanordnung (1) nach einem der vorhergehenden Ansprüche,
**dadurch gekennzeichnet, dass**
die Stromschiene (7) und das Verbindungselement (21) jeweils aus Blech, insbesondere Kupferblech gebildet sind.

## Claims

1. Contact arrangement (1) comprising a circuit carrier (18) and a busbar (7), wherein the circuit carrier (18) has at least one electrically insulating layer (19) and at least one electrically conductive layer (20) connected to the electrically insulating layer (19), wherein the circuit carrier (18) has an electrically conductive connection element (21) embodied in a resilient fashion, wherein the connection element (21) has at least one securing foot (30, 31, 32) connected to the electrically conductive layer (20) by soldering, wherein the connection element (21) has a connection section (22) arranged at a distance from the circuit carrier (18), wherein the busbar (7) is electrically and mechanically connected to the connection section (22), wherein the connection element (21) has three spacer legs (27, 28, 29) and the connection section (22) is connected to the respective spacer leg (27, 28, 29) in each case via a spring arm (23, 24, 25), wherein the spacer legs (27, 28, 29) each have a securing foot (30, 31, 32) integrally formed on the respective spring arm (23, 24, 25),
**characterized in that**
the spring arms extend in a manner pointing away radially in each case in the flat extent of the connection section and spring arms that are directly adjacent to one another form an angle of 120 degrees between one another, with the result that a star-shaped arrangement of the spring arms and the spacer legs is formed.

2. Contact arrangement (1) according to Claim 1, **characterized in that**
the connection element (21) is riveted to the busbar (7) by means of at least one rivet element (9) .

3. Contact arrangement (1) according to Claim 1, **characterized in that**
the connection element (21) is welded to the busbar (7), in particular welded by means of resistance welding.

4. Contact arrangement (1) according to Claim 1, **characterized in that**
the connection element (21) is soldered, in particular selectively soldered, to the busbar (7).

5. Contact arrangement (1) according to any of the preceding claims,
**characterized in that**
the spacer legs (27, 28, 29) extend transversely with respect to a flat extent of the connection section (22).

6. Contact arrangement (1) according to any of the preceding claims,
**characterized in that**
the busbar (7) and the connection element (21) are formed in each case from sheet metal, in particular copper sheet.

## Revendications

1. Système de contact (1) doté d'un porte-circuit (18) et d'un rail conducteur (7), dans lequel le porte-circuit (18) comporte au moins une couche électriquement isolante (19) et au moins une couche électriquement conductrice (20) reliée à la couche électriquement isolante (19), dans lequel le porte-circuit (18) comporte un élément de liaison (21) électriquement conducteur, réalisé de manière élastique, dans lequel l'élément de liaison (21) comporte au moins un pied de fixation (30, 31, 32) qui est soudé à la couche électriquement conductrice (20), dans lequel l'élément de liaison (21) comporte une partie de liaison (22) disposée de manière espacée du porte-circuit (18), dans lequel le rail conducteur (7) est relié électriquement et mécaniquement à la partie de liaison (22), dans lequel l'élément de liaison (21) comporte trois pattes d'écartement (27, 28, 29) et la partie de liaison (22) est reliée à la patte d'écartement (27, 28, 29) respective par l'intermédiaire d'un bras de ressort (23, 24, 25),
dans lequel les pattes d'écartement (27, 28, 29) comportent chacune un pied de fixation (30, 31, 32) qui est formé sur le bras de ressort respectif (23, 24, 25), **caractérisé en ce que** les bras de ressort s'étendent chacun radialement de manière espacée l'un de l'autre dans le prolongement plat de la partie de liaison et **en ce que** des bras de ressort directement adjacents forment entre eux un angle de 120 degrés, de sorte qu'il se forme un agencement en étoile des bras de ressort et des pattes d'écartement.

2. Système de contact (1) selon la revendication 1, **caractérisé en ce que**
l'élément de liaison (21) est riveté au rail conducteur (7) au moyen d'au moins un élément de rivet (9).

3. Système de contact (1) selon la revendication 1, **caractérisé en ce que**
l'élément de liaison (21) est soudé au rail conducteur (7), en particulier soudé par résistance.

4. Système de contact (1) selon la revendication 1, **caractérisé en ce que**
l'élément de liaison (21) est soudé, en particulier de manière sélective, au rail conducteur (7).

5. Système de contact (1) selon l'une des revendications précédentes, **caractérisé en ce que** les pattes d'écartement (27, 28, 29) s'étendent transversalement à un prolongement plat de la partie de liaison (22).

6. Système de contact (1) selon l'une des revendications précédentes, **caractérisé en ce que** le rail conducteur (7) et l'élément de liaison (21) sont chacun formés à partir d'une tôle, en particulier d'une tôle de cuivre.
